**Europäisches Patentamt**

**European Patent Office**

**Office européen des brevets**

(19)

(11) Veröffentlichungsnummer : **0 355 359 B1**

## (12) EUROPÄISCHE PATENTSCHRIFT

(45) Veröffentlichungstag der Patentschrift :
**17.03.93 Patentblatt 93/11**

(51) Int. Cl.$^5$ : **H01L 23/482,** H01L 29/743

(21) Anmeldenummer : **89112528.8**

(22) Anmeldetag : **08.07.89**

(54) **Abschaltbares Halbleiterbauelement.**

(30) Priorität : **19.08.88 CH 3105/88**

(43) Veröffentlichungstag der Anmeldung :
**28.02.90 Patentblatt 90/09**

(45) Bekanntmachung des Hinweises auf die
Patenterteilung :
**17.03.93 Patentblatt 93/11**

(84) Benannte Vertragsstaaten :
**CH DE GB IT LI**

(56) Entgegenhaltungen :
**EP-A- 0 098 175**
**EP-A- 0 194 946**

(73) Patentinhaber : **ASEA BROWN BOVERI AG
Haselstrasse
CH-5401 Baden (CH)**

(72) Erfinder : **Jaecklin, André, Dr.
Geissbergstrasse 55
CH-5400 Ennetbaden (CH)**
Erfinder : **Ramezani, Ezatollah, Dr.
Gugelweg 17
CH-115 Möriken (CH)**
Erfinder : **Vlasak, Thomas
Adelmatt 336
CH-5242 Birr (CH)**

## Beschreibung

Technisches Gebiet

Die vorliegende Erfindung bezieht sich auf das Gebiet der Leistungselektronik. Sie betrifft insbesondere ein abschaltbares Halbleiterbauelement, umfassend

(a) eine Halbleiterscheibe mit einer Folge unterschiedlich dotierter Schichten, welche zwischen einer Kathodenseite und einer Anodenseite angeordnet sind, und einen über ein Gate abschaltbaren Thyristor (GTO) bilden;

(b) auf der Kathodenseite der Halbleiterscheibe eine fein unterteilte Gate-Kathoden-Struktur mit einer Mehrzahl von inselförmigen Kathodenfingern, welche von einem Gatebereich umgeben sind;

(c) über den Kathodenfingern eine Kathodenmetallisierung;

(d) auf der Anodenseite der Halbleiterscheibe eine Anodenmetallisierung; und

(e) einen Anodenkontakt und einen Kathodenkontakt, welche zur Kontaktierung auf die Anodenmetallisierung bzw. in einer Mehrzahl von lokal begrenzten Bereichen auf die Kathodenmetallisierung gepresst werden;

Ein solches Halbleiterbauelement ist z.B. aus der Druckschrift EP-A-0 254 910 bekannt.

Stand der Technik

In der Leistungselektronik gewinnen zunehmend Halbleiterbauelemente an Bedeutung, die, anders als herkömmliche Thyristoren, direkt über ein Gate abgeschaltet werden können. Solche GTO(Gate Turn-Off)-Thyristoren enthalten auf einer grossflächigen Halbleiterscheibe eine Vielzahl von kleinflächigen, parallelgeschalteten Einzelthyristoren, auch Segmente genannt.

Jeder dieser Einzelthyristoren umfasst auf der Kathodenseite einen Kathodenfinger, der von einem zusammenhängenden Gatebereich umgeben ist und entweder selbst aus der Ebene des Gatebereichs herausragt oder planar ausgeführt und mit einer Kathodenmetallisierung versehen ist, welche in bestimmten Bereichen erhaben ist. Kathodenseitig ergibt sich daher eine stufenförmige, fein unterteilte Struktur, während die Halbleiterscheibe auf der Anodenseite üblicherweise nicht unterteilt und planar ausgeführt ist.

Die feinen und damit mechanisch empfindlichen Strukturen auf der Kathodenseite eines GTO führen zu Problemen bei der Kontaktierung bzw. beim Einbau solcher Bauelemente. Diese Probleme sind insbesondere auf die unterschiedliche lokale Druckverteilung auf der Anoden- und Kathodenseite der gepressten Halbleiterscheibe zurückzuführen.

In der eingangs genannten Druckschrift ist zur Lösung dieser Probleme ein sogenannter "direkter" Druckkontakt vorgeschlagen worden, bei dem die Halbleiterscheibe mit dem GTO-Aktivteil beidseitig mit einer Metallisierung versehen und im eingebauten Zustand zwischen grossflächigen Metallscheiben mit geringem Wärmeausdehnungskoeffizienten (z.B. Mo oder W) mit genügend hohem Druck gepresst wird. Der Druck erreicht hierbei, bezogen auf die totale Bauelementfläche, eine Grössenordnung von 10 MPa.

Da - wie vorher bereits erwähnt - beim GTO kathodenseitig eine Vielzahl von kleinflächigen Segmenten, anodenseitig dagegen eine zusammenhängende grosse Fläche vorliegt, ergibt sich ein typisches Verhältnis von Anodenfläche AA zu Kathodenfläche AK von

$$AA/AK = 2....10$$

Aus geometrischen Gründen (z.B. wegen eines ringförmigen Gatekontaktes, eines sog. Ringgates) ist dieses Flächenverhältnis bei dem in der Praxis wichtigen Hochstrom-GTO besonders gross. Je nach Dicke der Halbleiterscheibe ist die anodenseitige lokale Druckverteilung schwer definierbar (siehe dazu Kurve A1 in Fig.2), während die kathodenseitige lokale Druckverteilung (Kurve K in Fig.2) durch die einzelnen Segmente eindeutig vorgegeben und eng begrenzt ist.

Wegen dieser Verhältnisse ist einem relativ geringen mittleren Druck auf der Anodenseite ein weit höherer Druck auf der Kathodenseite zugeordnet, welcher dort in den meisten Fällen die Fliessgrenze der Kathodenmetallisierung ganzflächig oder zumindest lokal überschreitet. Daraus ergeben sich unerwünschte Deformationen der kathodenseitigen Metallschicht, die zu einem vorzeitigen Ausfall des Bauelements führen können (begrenzte Lastwechselfestigkeit). Falls andererseits zur Vermeidung dieser Deformationen der Druck gesenkt wird, ist auf der Anodenseite kein einwandfreier Kontakt mehr gewährleistet, sodass dort ein unerwünschter Spannungsabfall entstehen kann.

Darstellung der Erfindung

Aufgabe der vorliegenden Erfindung ist es nun, ein abschaltbares Halbleiterbauelement mit direktem Druckkontakt zu schaffen, bei dem durch eine verbesserte Druckverteilung die Funktionstüchtigkeit und Betriebssicherheit erheblich erhöht sind und der zulässige Bereich des von aussen anlegbaren Drucks erweitert wird.

Die Aufgabe wird bei einem Bauelement der eingangs genannten Art dadurch gelöst, dass

(f) die Anodenmetallisierung eine fein unterteilte Struktur aufweist, derart, dass auch der Anodenkontakt in einer Mehrzahl von lokal begrenzten Bereichen auf die Anodenmetallisierung gepresst wird; und

(g) die vom Anodenkontakt gepressten Bereiche den vom Kathodenkontakt gepressten Bereichen gegenüberliegen.

Der Kern der Erfindung besteht also darin, die Struktur der Metallisierungsschicht auf der Anodenseite jener der Kathodenseite anzupassen, sodass im Gegensatz zum herkömmlichen Bauelement annähernd symmetrische lokale Druckverteilungen resultieren.

Während im allgemeinen Fall der Erfindung die Kathodenseite der Halbleiterscheibe planar (siehe z.B. die DE-OS 36 16 233) oder stufenförmig ausgebildet sein kann, zeichnet sich gemäss einer ersten bevorzugten Ausführungsform der Erfindung das Bauelement dadurch aus, dass

(a) die Gate-Kathoden-Struktur stufenförmig mit erhabenen Kathodenfingern und einem tieferliegenden Gatebereich ausgebildet ist; und

(b) die von dem Kathodenkontakt gepressten Bereiche jeweils auf den Kathodenfingern angeordnet sind.

Eine weitere bevorzugte Ausführungsform der Erfindung zeichnet sich dadurch aus, dass

(a) die Halbleiterscheibe auf der Anodenseite eine plane Oberfläche aufweist; und

(b) die fein unterteilte Struktur der Anodenmetallisierung durch unterschiedliche Dicken in der Anodenmetallisierung erreicht wird.

Bei dieser Ausführungsform beschränkt sich die anodenseitige Strukturierung allein auf die Anodenmetallisierung, ohne dass die Halbleiterscheibe selbst verändert werden muss.

Eine dritte bevorzugte Ausführungsform der Erfindung ist dadurch gekennzeichnet, dass

(a) die Halbleiterscheibe auf der Anodenseite eine Oberfläche mit stufenförmiger Struktur aufweist;

(b) die stufenförmiger Struktur auf der Anodenseite im wesentlichen der stufenförmigen Gate-Kathoden-Struktur entspricht; und

(b) die Anodenmetallisierung die Halbleiterscheibe ganzflächig bedeckt.

Diese Ausführungsform ist mit fertigungstechnischen Vorteilen verbunden, wenn zum Strukturieren einer ursprünglich ganzflächigen p-Belegung für den Anodenemitter der nicht benötigte Teil ohnehin durch einen Aetzprozess entfernt wird.

Weitere Ausführungsbeispiele der Erfindung ergeben sich aus den Unteransprüchen.

## Kurze Beschreibung der Zeichnung

Die Erfindung soll nachfolgend anhand von Ausführungsbeispielen im Zusammenhang mit der Zeichnung näher erläutert werden, wobei ohne Beschränkung der Allgemeinheit ein Bauelement mit stufenförmiger Gate-Kathoden-Struktur zugrundegelegt wird.

Es zeigen

Fig.1 schematisch den Aufbau eines GTO-Thyristors mit direktem Druckkontakt nach dem Stand der Technik;

Fig.2 die lokale Druckverteilung für ein Thyristorsegment auf der Kathoden- und Anodenseite beim bekannten und beim erfindungsgemässen Bauelement im Vergleich;

Fig.3A,B die Segmentstruktur für ein Bauelement gemäss einer ersten bevorzugten Ausführungsform der Erfindung ohne (Fig.3A) und mit (Fig.3B) Anodenkurzschlüssen;

Fig.4A,B die Segmentstruktur für ein Bauelement gemäss einer zweiten bevorzugten Ausführungsform der Erfindung ohne (Fig.4A) und mit (Fig.4B) Anodenkurzschlüssen;

Fig.5A eine Ausführungsform des erfindungsgemässen Bauelements mit lokal begrenzten Metallisierungsbereichen;

Fig.5B eine Ausführungsform gemäss Fig.5A mit zusätzlicher ganzflächiger Metallisierungsschicht; und

Fig.6 die Strukturierung der Anodenmetallisierung im Bereich des Gatekontakts gemäss einer weiteren Ausführungsform der Erfindung.

## Wege zur Ausführung der Erfindung

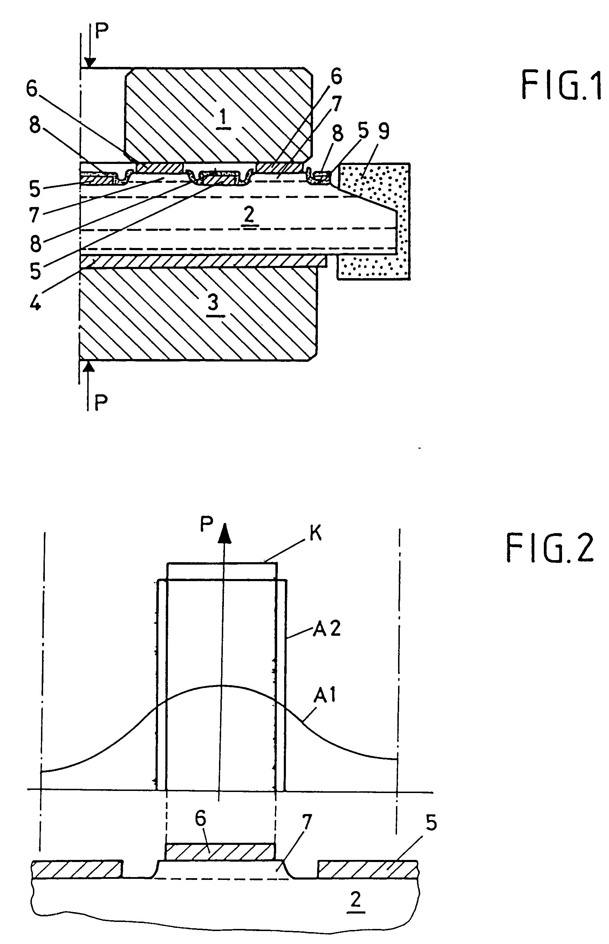

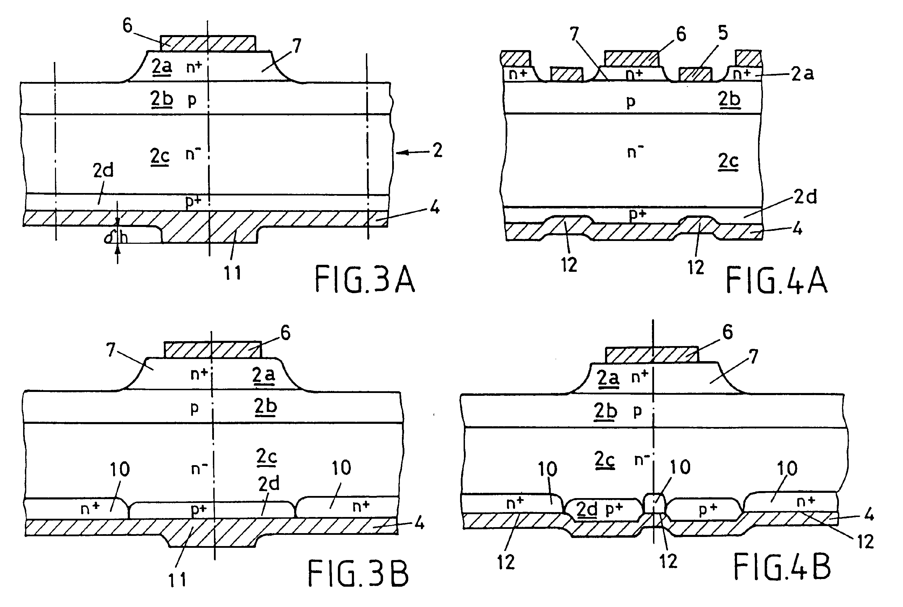

Ein abschaltbares Halbleiterbauelement mit direktem Druckkontakt und stufenförmiger Gate-Kathoden-Struktur nach dem Stand der Technik ist in Fig.1 schematisch im Aufbau dargestellt. Zentrales Bauteil dieser Anordnung ist eine grossflächige Halbleiterscheibe 2, welche den GTO-Aktivteil enthält.

Die Halbleiterscheibe 2 ist auf ihrer Unterseite (Anodenseite) grossflächig mit einer Anodenmetallisierung 4 versehen. Auf der Oberseite (Kathodenseite) weist sie eine stufenförmige Gate-Kathoden-Struktur auf, bei der eine Vielzahl von erhabenen Kathodenfingern 7 von einem tieferliegenden Gatebereich umgeben sind. Im Gatebereich selbst ist eine entsprechende Gatemetallisierung 5 angeordnet, die mit einem in der Figur nicht dargestellten Gatekontakt kontaktiert wird.

Die Kathodenfinger 7 tragen auf ihrer Oberseite jeweils eine Kathodenmetallisierung 6, die von gleicher Beschaffenheit (Dicke, Material) ist wie die Anodenmetallisierung 4. Zur Isolation sind schliesslich noch eine Isolationsschicht 8 in den Gatebereichen und eine Randpassivierung 9 am Rand der Halbleiterscheibe 2 vorgesehen.

Die Halbleiterscheibe 2 wird zwischen einem metallischen Anodenkontakt 3 und Kathodenkontakt 1 mit einem Druck P gepresst. Der Druck verteilt sich dabei kathodenseitig auf eine Vielzahl kleiner Druckflächen, nämlich der einzelnen Kathodenmetallisierungen 6 auf den Kathodenfingern 7, und ist über jede dieser kleinen Druckflächen weitgehend konstant.

Die kathodenseitige lokale Druckverteilung für ein Thyristorsegment hat damit die in Fig.2 als Kurve K wiedergegebene Form.

Dieser näherungsweise rechteckigen kathodenseitigen Druckverteilung steht beim Stand der Technik eine anodenseitige lokale Druckverteilung gegenüber, die weniger eng begrenzt ist und dafür einen deutlich geringeren Maximalwert aufweist (Kurve A1 in Fig.2). Dies bedeutet zugleich, dass einem relativ geringen mittleren Druck auf der Anodenseite, wie er zu einer sicheren Kontaktgabe (thermisch und elektrisch) notwendig ist, ein gefährlich hoher lokaler Druck auf den kleinen Flächen der Kathodenfinger 7 entspricht.

Um diese Unsymmetrie zu beseitigen, schlägt die Erfindung eine weitgehend symmetrische lokale Druckverteilung vor, bei der anodenseitig in etwa dieselbe rechteckige Kurve (A2 in Fig.2) vorliegt wie auf der Kathodenseite. Diese symmetrische Druckverteilung wird dadurch erreicht, dass die Anodenmetallisierung 4 in annähernd gleicher Weise strukturiert wird wie die stufenförmige Gate-Kathoden-Struktur auf der Anodenseite.

In einer ersten bevorzugten Ausführungsform (Fig.3A,B) wird die Struktur in der Anodenmetallisierung 4 direkt durch unterschiedliche Dicken der Metallisierung realisiert. Die Halbleiterscheibe 2 mit ihren unterschiedlich dotierten Schichten (n-Emitterschicht 2a, p-Basisschicht 2b, n-Basisschicht 2c und p-Emitterschicht 2d) hat dabei auf der Anodenseite eine plane Oberfläche und ist dort ganzflächig mit der Anodenmetallisierung 4 bedeckt.

Während die Anodenmetallisierung 4 ausserhalb der durch die Kathodenfinger 7 vorgegebenen Bereiche eine reduzierte Dicke aufweist, verdickt sie sich innerhalb jedes Segments zu einem Plateau 11, welches in Form und Ausdehnung im wesentlichen der gegenüberliegenden Kathodenmetallisierung 6 entspricht und symmetrisch zu dieser angeordnet ist.

Die Anodenmetallisierung 4 mit lokalem Plateau 11 ist gleichermassen anwendbar für Bauelemente ohne und mit Anodenkurzschlüssen 10 (Fig.3A bzw. Fig.3B). Sie kann realisiert werden durch photolithographische Strukturierung einer in herkömmlicher Weise aufgebrachten Metallschicht. Grundsätzlich kann für diese Metallschicht jedes für einen direkten Druckkontakt geeignete Metall verwendet werden. Bevorzugt wird A1, das in einem Aufdampf- oder Sputterverfahren aufgebracht wird.

Die Dicke der Anodenmetallisierung liegt zwischen 1μm und 30μm, vorzugsweise zwischen 5μm und 15μm. Damit die gewünschte Druckverteilung gemäss Kurven K und A2 in Fig.2 entsteht, ist eine minimale Höhendifferenz δh von wenigstens 1μm erforderlich (Fig.3A), weil dieser Wert etwa der unter Druck zu erwartenden elastischen Deformation entspricht. Dieser Höhenunterschied kann beispielsweise durch teilweises Aetzen der Metallisierungsschicht erzeugt werden.

In einer zweiten bevorzugten Ausführungsform (Fig.4A,B) wird nicht von einer planen Oberfläche auf der Anodenseite der Halbleiterscheibe 2 ausgegangen, sondern von einer stufenförmigen Oberfläche mit einer Struktur, die im wesentlichen der Gate-Kathoden-Struktur auf der Kathodenseite entspricht (Fig.4). Zu diesem Zweck sind in die Halbleiterscheibe 2 Vertiefungen 12 eingeätzt, die in Form und Ausdehnung in etwa den Gatebereichen auf der Kathodenseite entsprechen.

Die Anodenmetallisierung 4 ist in diesem Fall als gleichmässig dicke, ganzflächige Metallisierung ausgeführt, wodurch sich ausserhalb der Vertiefungen 12 Erhebungen in der Metallisierung ergeben, die den Plateaus 11 aus Fig.3A,B vergleichbar sind.

Beim Beispiel der Fig.4A sind Anodenkurzschlüsse nicht vorgesehen. Sind dagegen Anodenkurzschlüsse 10 vorhanden (Fig.4B), werden die Vertiefungen 12 überall dort angeordnet, wo die Kurzschlüsse liegen. Für den in Fig.4B dargestellten Fall, dass direkt unterhalb des Kathodenfingers 7 ein zentraler Anodenkurzschluss 10 eingebaut ist, teilt sich die druckbelastete Fläche auf der Anodenseite auf und richtet sich in Grösse und Ausdehnung nach der darunterliegenden p-Emitterschicht 2d.

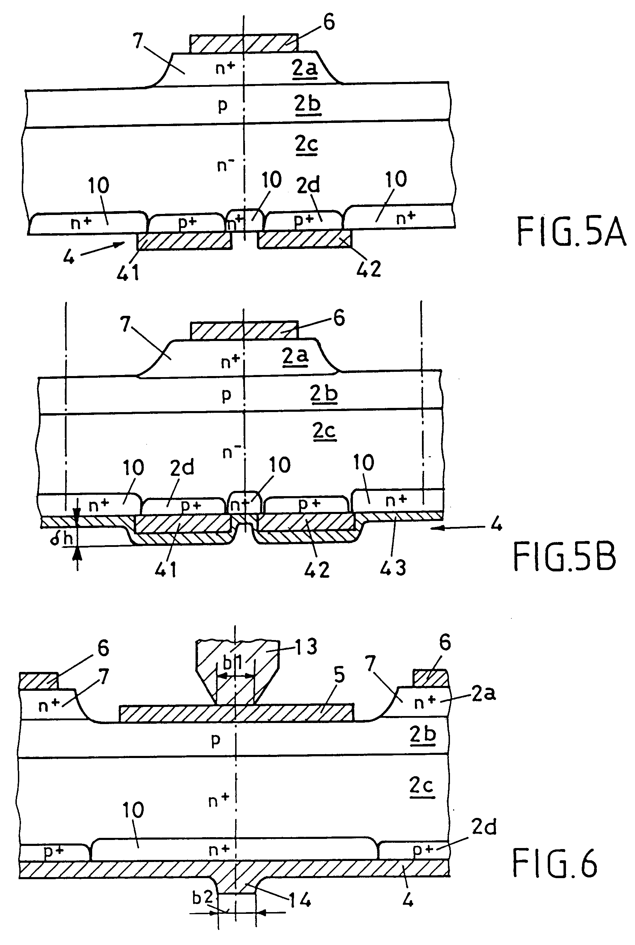

Dies wird noch deutlicher an einer anderen Ausführungsform gemäss Fig.5A, bei der die anodenseitige Oberfläche der Halbleiterscheibe 2 zwar plan ist, jedoch anstelle einer ganzflächigen Metallisierung mit entsprechend plazierten Plateaus nun einzelne, lokal begrenzte Metallisierungsbereiche 41,42 vorgesehen sind.

Die Metallisierungsbereiche 41,42 bedecken bei der Anwesenheit von Anodenkurzschlüssen 10 im wesentlichen die p-Emitterschicht 2d und überlappen zusätzlich noch die Bereiche der Anodenkurzschlüsse 10, um deren einwandfreie Funktion sicherzustellen. Dieselbe Funktion kann eine zusätzliche ganzflächige Metallisierungsschicht 43 gemäss Fig.5B übernehmen, die ausserdem eine verbesserte anodenseitige Wärmeabfuhr gestattet.

Die erfindungsgemässe Symmetrierung der Druckverteilung ist jedoch nicht nur auf die Bereiche der einzelnen Segmente bzw. Kathodenfinger beschränkt, sondern kann ebensogut auch in der Gateregion angewendet werden (Fig.6), unabhängig davon, ob es sich um ein Zentralgate oder um ein Ringgate handelt. In beiden Fällen drückt kathodenseitig ein Gatekontakt 13 auf die Gatemetallisierung 5. Dem Gatekontakt 13 gegenüberliegend kann dann in der Anodenmetallisierung 4 ein Plateau 14 vorgesehen werden, welches in Form und Ausdehnung der vom Gatekontakt 13 gedrückten Fläche im wesentlichen entspricht. Bei einem Ringgate mit einem ringförmigen Gatekontakt 13 und einer Ringbreite b1 hat das Plateau 14 dann ebenfalls ringförmige Gestalt und eine Ringbreite b2, die der Ringbreite b1 in etwa gleich ist.

Wie bereits erwähnt, ist die Erfindung nicht auf Bauelemente mit stufenförmiger Gate-Kathoden-Struktur beschränkt, sondern kann in gleicher Weise auch auf Bauelemente mit planarer kathodenseitiger Oberfläche der Halbleiterscheibe angewendet werden, wie sie aus der vorgenannten DE-OS 36 16 233 bekannt sind.

Insgesamt lassen sich mit der erfindungsgemässen Anpassung der anodenseitigen Metallisierungsstruktur an die kathodenseitige Gate-Kathoden-Struktur Bauelemente realisieren, die besonders funktionssicher und langlebig sind.

## Patentansprüche

1. Abschaltbares Halbleiterbauelement, umfassend
   (a) eine Halbleiterscheibe (2) mit einer Folge unterschiedlich dotierter Schichten (2a-d), welche zwischen einer Kathodenseite und einer Anodenseite angeordnet sind, und einen über ein Gate abschaltbaren Thyristor (GTO) bilden;
   (b) auf der Kathodenseite der Halbleiterscheibe (2) eine fein unterteilte Gate-Kathoden-Struktur mit einer Mehrzahl von inselförmigen Kathodenfingern (7), welche von einem Gatebereich umgeben sind;
   (c) über den Kathodenfingern (7) eine Kathodenmetallisierung (6);
   (d) auf der Anodenseite der Halbleiterscheibe (2) eine Anodenmetallisierung (4); und
   (e) einen Anodenkontakt (3) und einen Kathodenkontakt (1), welche zur Kontaktierung auf die Anodenmetallisierung (4) bzw. in einer Mehrzahl von lokal begrenzten Bereichen auf die Kathodenmetallisierung (6) gepresst werden;
   dadurch gekennzeichnet, dass
   (f) die Anodenmetallisierung (4) eine fein unterteilte Struktur aufweist, derart, dass auch der Anodenkontakt (3) in einer Mehrzahl von lokal begrenzten Bereichen auf die Anodenmetallisierung (4) gepresst wird; und
   (g) die vom Anodenkontakt (3) gepressten Bereiche den vom Kathodenkontakt (1) gepressten Bereichen gegenüberliegen.

2. Abschaltbares Halbleiterbauelement nach Anspruch 1, dadurch gekennzeichnet, dass
   (a) die Gate-Kathoden-Struktur stufenförmig mit erhabenen Kathodenfingern (7) und einem tieferliegenden Gatebereich ausgebildet ist; und
   (b) die von dem Kathodenkontakt (1) gepressten Bereiche jeweils auf den Kathodenfingern (7) angeordnet sind.

3. Abschaltbares Halbleiterbauelement nach Anspruch 2, dadurch gekennzeichnet, dass
   (a) die Halbleiterscheibe (2) auf der Anodenseite eine plane Oberfläche aufweist; und
   (b) die fein unterteilte Struktur der Anodenmetallisierung (4) durch unterschiedliche Dicken in der Anodenmetallisierung (4) erreicht wird.

4. Abschaltbares Halbleiterbauelement nach Anspruch 3, dadurch gekennzeichnet, dass
   (a) die Anodenmetallisierung (4) die Halbleiterscheibe (2) auf der Anodenseite ganzflächig bedeckt; und
   (b) die Anodenmetallisierung (4) in jedem einem Kathodenfinger (7) gegenüberliegenden Bereich ein Plateau (11) aufweist, welches in Form und Ausdehnung im wesentlichen gleich dem gepressten Bereich auf dem gegenüberliegenden Kathodenfinger (7) ist.

5. Abschaltbares Halbleiterbauelement nach Anspruch 3, dadurch gekennzeichnet, dass
   (a) die Anodenmetallisierung (4) eine Vielzahl von lokal begrenzten Metallisierungsbereichen (41,42) umfasst; und
   (b) die Metallisierungsbereiche (41,42) jeweils in dem einem Kathodenfinger (7) gegenüberliegenden Bereich angeordnet sind.

6. Abschaltbares Halbleiterbauelement nach Anspruch 5, dadurch gekennzeichnet, dass
   (a) innerhalb der Halbleiterscheibe (2) auf der Anodenseite eine p-Emitterschicht (2d) angeordnet ist;
   (b) die p-Emitterschicht (2d) von Anodenkurzschlüssen (10) durchbrochen wird; und
   (c) die Metallisierungsbereiche (41,42) im wesentlichen die p-Emitterschicht (2d) bedecken.

7. Abschaltbares Halbleiterbauelement nach Anspruch 5, dadurch gekennzeichnet, dass die Anodenmetallisierung (4) zusätzlich eine Metallisierungsschicht (43) umfasst, welche die Halbleiterscheibe (2) einschliesslich der Metallisierungsbereiche (41,42) auf der Anodenseite ganzflächig bedeckt.

8. Abschaltbares Halbleiterbauelement nach Anspruch 2, dadurch gekennzeichnet, dass
   (a) die Halbleiterscheibe (2) auf der Anodenseite eine Oberfläche mit stufenförmiger Struktur aufweist;
   (b) die stufenförmigen Struktur auf der Anodenseite im wesentlichen der stufenförmigen Gate-Kathoden-Struktur entspricht; und
   (b) die Anodenmetallisierung (4) die Halbleiterscheibe (2) ganzflächig bedeckt.

9. Abschaltbares Halbleiterbauelement nach Anspruch 2, dadurch gekennzeichnet, dass

(a) die Halbleiterscheibe (2) auf der Anodenseite innerhalb des Gatebereichs mit einer Gatemetallisierung (5) versehen ist;

(b) ein Gatekontakt (13) vorgesehen ist, welcher auf die Gatemetallisierung (5) drückt; und

(c) die Anodenmetallisierung (4) auf der dem Gatekontakt (5) gegenüberliegenden Seite ein Plateau (14) aufweist, welches in seiner Ausdehnung im wesentlichen der vom Gatekontakt (13) gedrückten Fläche entspricht.

10. Abschaltbares Halbleiterbauelement nach Anspruch 1, dadurch gekennzeichnet, dass

(a) die Anodenmetallisierung (4) aus A1 besteht; und

(b) die Dicke der Anodenmetallisierung (4) zwischen 1μm und 30μm beträgt.

11. Abschaltbares Halbleiterbauelement nach Anspruch 10, dadurch gekennzeichnet, dass die Dicke der Anodenmetallisierung zwischen 5μm und 15μm beträgt.

12. Abschaltbares Halbleiterbauelement nach Anspruch 1, dadurch gekennzeichnet, dass die vom Anodenkontakt (3) gepressten Bereiche und die nicht gepressten Bereiche auf der Anodenseite eine Höhendifferenz ($\delta$h) von wenigstens 1μm aufweisen.

## Claims

1. Semiconductor component with turn-off facility comprising

(a) a semiconductor wafer (2) containing a sequence of differently doped layers (2a-d) which are arranged between a cathode side and an anode side and form a gate turn-off thyristor (GTO) by means of a gate;

(b) on the cathode side of the semiconductor wafer (2), a finely subdivided gate-cathode structure having a multiplicity of island-like cathode fingers (7) surrounded by a gate region;

(c) a cathode metallisation (6) over the cathode fingers (7):

(d) an anode metallisation (4) on the anode side of the semiconductor wafer (2); and

(e) an anode contact (3) and a cathode contact (1) which are pressed onto the anode metallisation (4) or, in a multiplicity of locally limited regions, onto the cathode metallisation (6), respectively, for the purpose of making contact,

characterised in that

(f) the anode metallisation (4) has a finely subdivided structure such that the anode contact (3) is also pressed onto the anode metallisation in a multiplicity of locally limited regions; and

(g) the regions pressed by the anode contact (3) are situated opposite the regions pressed by the cathode contact (1).

2. Semiconductor component with turn-off facility according to Claim 1, characterised in that

(a) the gate-cathode structure is of stepped construction with elevated cathode fingers (7) and a lower-lying gate region; and

(b) the regions pressed by the cathode contact (1) are in each case arranged on the cathode fingers (7).

3. Semiconductor component with turn-off facility according to Claim 1, characterised in that

(a) the semiconductor wafer (2) has a flat surface on the anode side; and

(b) the finely subdivided structure of the anode metallisation (4) is achieved by different thicknesses in the anode metallisation (4).

4. Semiconductor component with turn-off facility according to Claim 3, characterised in that

(a) the anode metallisation (4) covers the semiconductor wafer (2) on the anode side over the entire area;

(b) the anode metallisation (4) has a plateau (11) which is essentially equal in shape and extent to the pressed region on the oppositely situated cathode finger (7) in each region situated opposite a cathode finger (7).

5. Semiconductor component with turn-off facility according to Claim 3, characterised in that

(a) the anode metallisation (4) comprises a multiplicity of locally limited metallisation regions (41, 42); and

(b) the metallisation regions (41, 42) are arranged in each case in a region situated opposite a cathode finger (7).

6. Semiconductor component with turn-off facility according to Claim 5, characterised in that

(a) a p-type emitter layer (2d) is arranged inside the semiconductor wafer (2) on the anode side;

(b) the p-type emitter layer (2d) is interrupted by anode short circuits (10); and

(c) the metallisation regions (41, 42) essentially cover the p-type emitter layer (2d).

7. Semiconductor component with turn-off facility according to Claim 5, characterised in that the anode metallisation (4) additionally comprises a metallisation layer (43) which covers the semiconductor wafer (2) on the anode side over the entire area including the metallisation regions (41, 42).

8. Semiconductor component with turn-off facility according to Claim 2, characterised in that
(a) the semiconductor wafer (2) has a surface with stepped structure on the anode side;
(b) the stepped structure on the anode side essentially corresponds to the step gate-cathode structure; and
(c) the anode metallisation (4) covers the semiconductor wafer (2) over the entire surface.

9. Semiconductor component with turn-off facility according to Claim 2, characterised in that
(a) the semiconductor wafer (2) is provided with a gate metallisation (5) on the cathode side inside the gate region;
(b) a gate contact (13) which presses on the gate metallisation (5) is provided; and
(c) on the side situated opposite the gate contact (5), the anode metallisation (4) has a plateau (14) which corresponds in its extent essentially to the area pressed by the gate contact (13).

10. Semiconductor component with turn-off facility according to Claim 1, characterised in that
(a) the anode metallisation (4) is composed of Al; and
(b) the thickness of the anode metallisation (4) is between 1μm and 30μm.

11. Semiconductor component with turn-off facility according to Claim 10, characterised in that the thickness of the anode metallisation is between 5μm and 15μm.

12. Semiconductor component with turn-off facility according to Claim 1, characterised in that the regions pressed by the anode contact (3) and the unpressed regions on the anode side have a difference in height (δh) of at least 1μm.

## Revendications

1. Composant semi-conducteur déclenchable, comprenant :
(a) une pastille semi-conductrice (2) présentant une succession de couches dopées de manière différente (2a-d) qui sont disposées entre un côté de cathode et un côté d'anode et forment un thyristor déclenchable par la gâchette (GTO);
(b) sur le côté de cathode de la pastille semi-conductrice (2), une structure de cathode-gâchette finement subdivisée, comportant une pluralité de doigts de cathode formant îlot (7) qui sont entourés par un domaine de gâchette;
(c) une métallisation de cathode (6) par-dessus les doigts de cathode (7);
(d) sur le côté d'anode de la pastille semi-conductrice ( 2 ), une métallisation d'anode ( 4 ), et
(e) un contact d'anode (3) et un contact de cathode (1) qui, en vue d'une mise en contact, sont pressés respectivement sur la métallisation d'anode (4) et, dans une pluralité de zones limitées localement, sur la métallisation de cathode (6),
caractérisé en ce que
(f) la métallisation d'anode (4) présente une structure finement subdivisée, de telle sorte que le contact d'anode (3) également soit pressé dans une pluralité de zones limitées localement sur la métallisation d'anode (4), et
(g) les zones pressées par le contact d'anode (3) sont opposées aux zones pressées par le contact de cathode (1).

2. Composant semi-conducteur déclenchable suivant la revendication 1, caractérisé en ce que
(a) la structure de cathode-gâchette est d'une conception étagée avec des doigts de cathode (7) en relief et une zone de gâchette en contrebas, et
(b) les zones pressées par le contact de cathode (1) sont disposées chaque fois sur les doigts de cathode (7).

3. Composant semi-conducteur déclenchable suivant la revendication 2, caractérisé en ce que
(a) la pastille semi-conductrice (2) présente une surface plane du côté d'anode, et
(b) la structure finement subdivisée de la métallisation d'anode (4) est obtenue par des épaisseurs différentes dans la métallisation d'anode (4).

4. Composant semi-conducteur déclenchable suivant la revendication 3, caractérisé en ce que
(a) la métallisation d'anode (4) recouvre toute la surface de la pastille semi-conductrice (2) du côté d'anode, et
(b) la métallisation d'anode (4) présente, dans chaque zone opposée à un doigt de cathode (7), un plateau (11) dont la forme et l'étendue sont en substance pareilles à celles de la zone pressée sur le doigt de cathode (7) opposé.

5. Composant semi-conducteur déclenchable suivant la revendication 3, caractérisé en ce que
(a) la métallisation d'anode (4) comprend une pluralité de zones de métallisation localement limitées (41, 42), et
(b) les zones de métallisation (41, 42) sont chaque fois disposées dans la zone opposée à un doigt de cathode (7).

6. Composant semi-conducteur déclenchable suivant la revendication 5, caractérisé en ce que
(a) à l'intérieur de la pastille semi-conductrice (2), sur le côté d'anode, est disposée une couche d'émetteur de type p (2d);
(b) la couche d'émetteur de type p (2d) est percée par des courts-circuits d'anode (10), et
(c) les zones de métallisation (41, 42) recouvrent en substance la couche d'émetteur de type p (2d).

7. Composant semi-conducteur déclenchable suivant la revendication 5, caractérisé en ce que la métallisation d'anode (4) comprend, en outre, une couche de métallisation (43) qui recouvre la pastille semi-conductrice (2) sur toute sa surface du côté d'anode y compris les zones de métallisation (41, 42).

8. Composant semi-conducteur déclenchable suivant la revendication 2, caractérisé en ce que
(a) la pastille semi-conductrice (2) présente, du côté d'anode, une surface à structure étagée;
(b) la structure étagée du côté d'anode correspond en substance à la structure de cathode-gâchette étagée, et
(c) la métallisation d'anode (4) recouvre toute la surface de la pastille semi-conductrice (2).

9. Composant semi-conducteur déclenchable suivant la revendication 2, caractérisé en ce que
(a) la pastille semi-conductrice (2) est pourvue, du côté de cathode, à l'intérieur de la zone de gâchette, d'une métallisation de gâchette (5);
(b) un contact de gâchette (13) est prévu, pressant sur la métallisation de gâchette (5), et
(c) la métallisation d'anode (4) présente, du côté opposé au contact de gâchette (5), un plateau (14) dont l'extension correspond en substance à la surface pressée par le contact de gâchette (13).

10. Composant semi-conducteur déclenchable suivant la revendication 1, caractérisé en ce que

(a) la métallisation d'anode (4) est faite de Al, et
(b) l'épaisseur de la métallisation d'anode (4) est comprise entre 1 μm et 30 μm.

11. Composant semi-conducteur déclenchable suivant la revendication 10, caractérisé en ce que l'épaisseur de la métallisation d'anode est comprise entre 5 μm et 15 μm.

12. Composant semi-conducteur déclenchable suivant la revendication 1, caractérisé en ce que les zones pressées par le contact d'anode (3) et les zones non pressées, du côté d'anode, présentent une différence de hauteur (δh) d'au moins 1 μm.

FIG.1

FIG.2

FIG.4A

FIG.4B

FIG.3A

FIG.3B

FIG.5A

FIG.5B

FIG.6